# FASCICULE DE BREVET EUROPEEN

(11) **EP 3 804 117 B1**
(45) Date de publication et mention de la délivrance du brevet: **25.03.2026**
(21) Numéro de dépôt: 19730207.8
(22) Date de dépôt: 15.05.2019
(51) Int. Cl.: H02N 2/18

(54) **RÉCUPÉRATEUR D'ÉNERGIE VIBRATOIRE**
VIBRATIONSENERGIEUMWANDLER
VIBRATION ENERGY HARVESTER

(30) Priorité: 29.05.2018 FR 1870615
(43) Date de publication de la demande: 14.04.2021
(73) Titulaire: Université Savoie Mont Blanc, 73011 Chambéry Cedex (FR); Institut National des Sciences Appliquees de Lyon (Insa Lyon), 69100 Villeurbanne (FR)
(72) Inventeur: BADEL, Adrien, 73340 Lescheraines (FR); FORMOSA, Fabien, 74940 Annecy-Le-Vieux (FR); HUGUET, Thomas, 31490 Brax (FR)
(74) Mandataire: Talbot, Alexandre
(86) Numéro de dépôt international: PCT/FR2019/051111
(87) Numéro de publication internationale: WO 2019/229319

(56) Documents cités:
- EP-A1- 3 107 202
- WO-A1-02/29965
- US-A1- 2008 100 181
- US-A1- 2012 119 620
- CORVES B ET AL: "Mechanische Konstruktionselemente", 30 November 2006, TASCHENBUCH F�R DEN MASCHINENBAU : MIT TABELLEN, SPRINGER, DE, PAGE(S) G1 - G189, ISBN: 978-3-540-49714-1, XP009546547

## Description

### Domaine

La présente description concerne de façon générale les récupérateurs d'énergie et, plus particulièrement, les dispositifs de récupération d'énergie vibratoire, adaptés à produire de l'électricité à partir de vibrations mécaniques. La présente description s'applique notamment à la production d'électricité par des équipements susceptibles de vibrer, par exemple des gaines de climatisation d'un bâtiment, des ordinateurs en fonctionnement, des machines industrielles, des moteurs, des véhicules, des infrastructures de transport, etc.

### État de l'art antérieur

On sait depuis longtemps qu'il est possible de récupérer de l'électricité à partir de vibrations d'un système mécanique. Certains convertisseurs mécano-électriques ou récupérateurs vibratoires utilisent des éléments piézoélectriques pour convertir une énergie mécanique provenant des vibrations en électricité.

Un exemple de générateur électrique à récupération d'énergie de vibrations mécaniques est décrit dans le document WO A 2011/073591 (B9966PCT).

Le document US-A-2008/0100181 décrit un système et un procédé de générateur mécano-électrique piézoélectrique non linéaire.

Le document US-A-2012/0119620 décrit un appareil et un procédé d'amplification de force multiétages d'empilements piézoélectriques.

Le document WO-A-2002/029965 décrit un collecteur d'énergie piézoélectrique.

Le document EP 3 107 202 A1 décrit un collecteur d'énergie piézoélectrique sans liaison glissière au niveau d'une paroi du cadre avec le dispositif de conversion se trouvant à l'intérieur du cadre.

### Résumé

Il existe un besoin d'amélioration des convertisseurs mécano-électriques en termes d'industrialisation.

Il existe également un besoin d'amélioration des générateurs électriques à récupération d'énergie de vibrations mécaniques en termes de fiabilité.

Un mode de réalisation pallie tout ou partie des inconvénients des récupérateurs d'énergie vibratoire usuels.

Un mode de réalisation prévoit un dispositif de récupération d'énergie mécanique vibratoire telle que défini par la revendication 1.

Selon un mode de réalisation, ladite liaison glissière est obtenue par un élément coulissant dans ladite paroi et reliant ladite structure audit dispositif de conversion.

Selon un mode de réalisation, ladite liaison glissière est obtenue par une déformation de ladite paroi entre ladite structure et ledit dispositif de conversion.

Selon un mode de réalisation, le dispositif de conversion est relié à un point fixe par rapport au cadre.

Selon un mode de réalisation, au moins une masse est fixée en partie centrale de la structure à lames.

Selon un mode de réalisation, la structure à lames est mise en flambage entre le cadre et ladite liaison glissière.

Selon un mode de réalisation, le dispositif de conversion comporte un élément piézoélectrique dans une direction approximativement perpendiculaire à la direction de la structure à lames.

Selon un mode de réalisation, le dispositif de conversion comporte une armature en forme de double arceau, les milieux des arceaux étant reliés respectivement à la liaison glissière et au point fixe.

Un mode de réalisation prévoit un système de production d'électricité comportant un équipement soumis à des vibrations mécaniques et un dispositif de récupération d'énergie mécanique vibratoire.

Selon un mode de réalisation, le dispositif est fixé à l'équipement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue très schématique illustrant le principe de fonctionnement d'un générateur électrique de récupération d'énergie mécanique de vibration, de type bistable ;
la figure 2 est une vue en plan très schématique d'un mode de réalisation d'un dispositif de récupération d'énergie vibratoire et de conversion en énergie électrique ;
la figure 3 est une vue en perspective schématique et partielle d'un mode de réalisation d'une liaison glissière d'une structure à lames à un dispositif de conversion mécano-électrique ;
la figure 4 est une vue en plan très schématique d'un autre mode de réalisation d'un dispositif de récupération d'énergie vibratoire et de conversion en énergie électrique ;
la figure 5 est une vue en perspective schématique et partielle d'un autre mode de réalisation d'une liaison glissière d'une structure à lames à un dispositif de conversion mécano-électrique ; et
la figure 6 est une vue agrandie d'un mode de réalisation d'un dispositif de conversion d'énergie adapté aux modes de réalisation de récupérateurs d'énergie décrits.

### Description détaillée

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le système, équipement, dispositif ou environnement, fournissant l'énergie vibratoire (les vibrations) n'a pas été détaillé, les modes de réalisation décrits étant compatibles avec les sources usuelles de vibrations dans des applications de conversion en énergie électrique. De plus, l'utilisation faite de l'énergie électrique récupérée n'a pas non plus été détaillée, les modes de réalisation décrits étant, là encore, compatibles avec les applications usuelles des récupérateurs d'énergie et de conversion en électricité.

Sauf précision contraire, lorsque l'on fait référence à deux éléments connectés ou fixés entre eux, cela signifie directement reliés sans élément intermédiaire autre qu'un liant de type colle, soudure ou vissage, et lorsque l'on fait référence à deux éléments associés ou couplés entre eux, cela signifie que ces deux éléments peuvent être directement reliés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

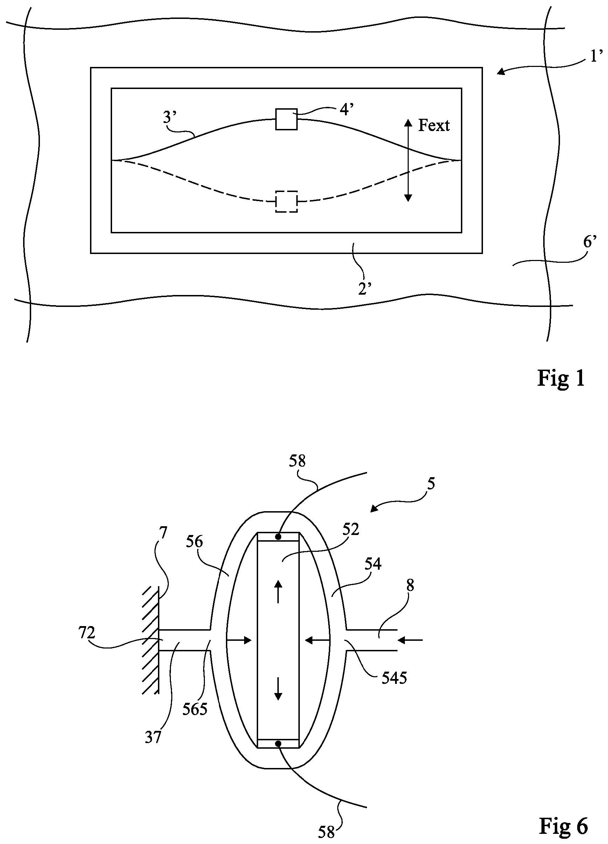

La figure 1 est une vue très schématique illustrant le principe de fonctionnement d'un générateur électrique l' de récupération d'énergie mécanique de vibration, de type bistable.

Le générateur l' comprend un boîtier de support et de protection 2', de forme générale parallélépipédique, adapté à être monté sur une surface vibrante 6' d'un équipement susceptible de vibrer. Dans cet exemple, les vibrations extérieures sont susceptibles d'exercer, sur le boîtier 2', une excitation dont l'effet peut être représenté schématiquement par une force d'orientation Fext. Le boîtier 2' contient une lame ressort 3' dont les deux extrémités s'appuient, en compression, sur deux faces latérales opposées du boîtier. Les deux points d'appui de la lame 3' sur le boîtier 2' sont placés selon un axe sensiblement orthogonal à l'orientation Fext des vibrations. Une masse 4' est fixée à la lame 3', sensiblement en son milieu. La lame 3', en compression entre ses deux extrémités, et la masse 4', définissent un système non linéaire, ou bistable, qui peut, sous l'effet des vibrations extérieures, passer de l'une à l'autre de deux positions d'équilibre stable (représentées respectivement en trait plein et en traits pointillés sur la figure). Ce système peut également osciller autour de chacune des deux positions d'équilibre. Un convertisseur mécano-électrique (non représenté), de type piézoélectrique, est prévu pour convertir le mouvement de la lame 3' et de la masse 4', en énergie électrique.

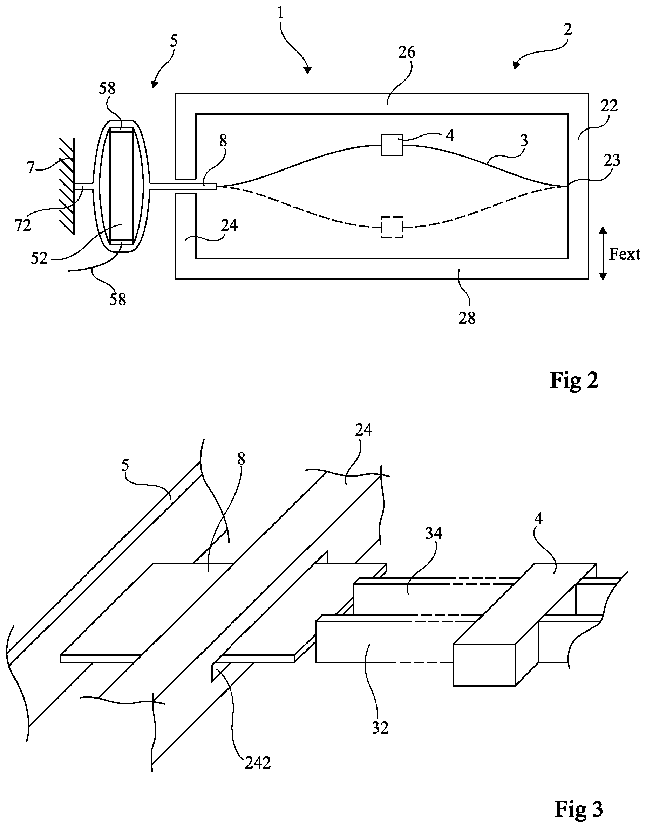

La figure 2 est une vue en plan très schématique d'un mode de réalisation d'un dispositif 1 de récupération d'énergie vibratoire et de conversion en énergie électrique.

Selon les modes de réalisation décrits, le dispositif 1 de récupération d'énergie comporte un boîtier support pourvu d'un cadre rigide 2, formé de parois 22, 24, 26, 28. Le boîtier est par exemple refermé par deux plaques (non représentées), de part et d'autre du cadre 2, afin de protéger l'intérieur de la poussière ou autre.

Une structure à lames ressort 3 bistable, associée à au moins une masse 4, constitue le mécanisme de récupération de l'énergie vibratoire. Selon les modes de réalisation décrits, la structure à lames ressort est une structure comportant deux lames parallèles entre elles, par exemple du type décrit par la suite en relation avec la figure 3.

Une extrémité de la structure à lames 3 est fixée à un côté 22 du cadre (point 23). L'autre extrémité de la structure 3 est reliée à un élément 8, monté en translation à travers la paroi opposée 24 du cadre 2. Cet élément 8 est destiné à coulisser à travers la paroi 24 dans une direction approximativement parallèle à la direction médiane de la structure 3 bistable.

L'élément 8 relie, de façon rigide, la structure à lames 3 à un dispositif 5 de conversion d'énergie mécano-électrique. Le dispositif 5 comporte un élément piézoélectrique 52 contraint, dans l'exemple représenté, par une armature, généralement désignée flextenseur, ici en forme de double arceau 54, 56, ou de losange. Le dispositif 5 est, du côté opposé à l'élément 8, relié à un point fixe 72, par exemple d'un châssis 7, par rapport à la paroi 22 du cadre 2. En d'autres termes, la distance entre l'extrémité de la structure à lames 3 et le point 72 est constante. Cela permet de préserver le fonctionnement bistable du récupérateur malgré la liaison coulissante à travers la paroi 24. Par exemple, le châssis 7 fait partie d'un deuxième cadre relié rigidement au cadre 2.

Ainsi, on prévoit de placer le dispositif de conversion 5, à base d'élément piézoélectrique, à l'extérieur du cadre boîtier 2. Un avantage est que cela évite un passage de fils conducteurs 58 à travers les parois du cadre.

La figure 3 est une vue en perspective schématique et partielle d'un mode de réalisation d'un élément 8 coulissant de liaison glissière d'une structure à lames 3 à un dispositif 5. La figure 3 illustre également un mode de réalisation de la structure à lames 3.

Selon ce mode de réalisation, la structure 3 est constituée de deux lames 32 et 34 parallèles entre elles. La masse 4 est fixée aux deux lames dans leur milieu. Un avantage d'une structure à double lame est que cela évite une torsion de la structure à lames et contraint le sens d'oscillation.

De préférence, l'espace entre les deux lames 32 et 34 est maintenu constant. Dans l'exemple de la figure 3, cet espace est maintenu constant par les fixations respectives des lames à la masse 4, au cadre (point 23) pour une extrémité de la structure et à l'élément 8 pour l'autre extrémité.

Selon le mode de réalisation représenté en figure 3, l'élément 8 a la forme d'une plaque disposée perpendiculairement aux lames 32 et 34. L'élément 8 est monté à coulissement dans une lumière 242 du bord 24 du cadre pour être relié au dispositif 5.

Un avantage de ce mode de réalisation est que l'on évite une torsion du système.

Selon un autre mode de réalisation, l'élément 8 est une tige cylindrique monté à coulissement dans la paroi 24. De préférence, pour éviter toute torsion de la structure à lames 3, on préférera alors une tige de section ovale à une tige de section ronde.

Tout autre type de liaison glissière d'un point de vue cinématique (en translation dans l'axe de la structure à lames 3) sans rotation (afin d'éviter une torsion de la structure bistable 3) peut convenir.

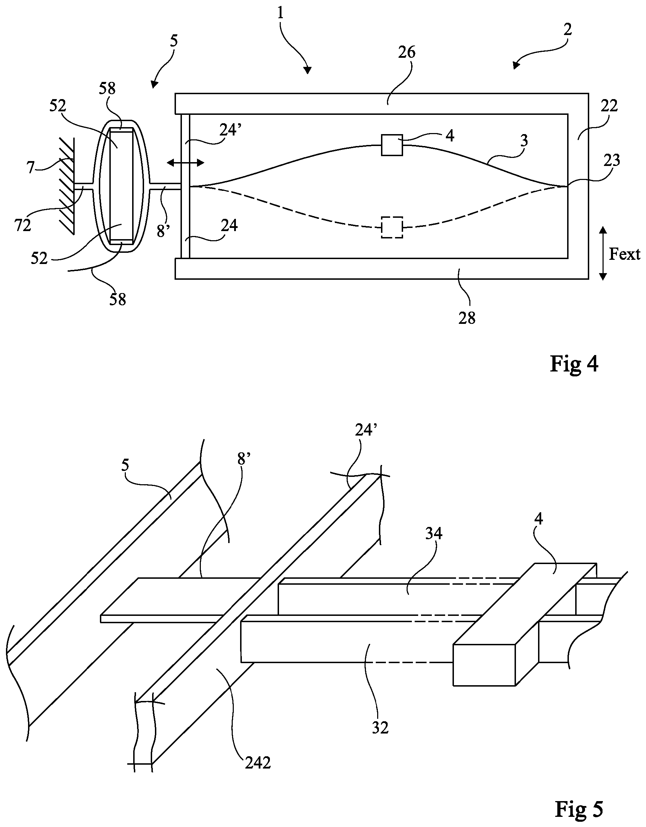

La figure 4 est une vue en plan très schématique d'un autre mode de réalisation d'un dispositif 1 de récupération d'énergie vibratoire et de conversion en énergie électrique.

On notera que, comme pour la figure 2, la structure à deux lames parallèles n'est pas détaillée en figure 4 par soucis de simplification du tracé. Néanmoins, que ce soit dans le mode de réalisation de la figure 2 ou dans celui de la figure 4, on prévoit une structure à deux lames parallèles entre elles.

Par rapport au mode de réalisation de la figure 2, la liaison glissière entre la structure à lames 3 et le dispositif 5 de conversion d'énergie électrique n'est pas coulissante, mais est obtenue par une paroi 24' souple entre la structure à lames 3 et le dispositif 5. Dans l'exemple de la figure 4, cela est schématisé par une paroi 24' plus fine que les autres parois 22, 26 et 28 du cadre boîtier 2. Toutefois, le même effet peut par exemple être obtenu avec une paroi 24' en un matériau différent. La structure à lames 3 d'un côté et un élément 8' de liaison du dispositif 8 à la paroi 24' portent, dans ce mode de réalisation, directement contre la paroi 24'.

Un avantage d'une telle liaison glissière sans coulissement est que l'on évite les frottements, ce qui optimise la transmission des efforts axialement.

La figure 5 est une vue en perspective schématique et partielle d'une liaison glissière sans coulissement d'une structure à lames 3 à un dispositif 5.

Selon cet exemple, les deux lames 32 et 34 portent directement par leurs extrémités respectives côté dispositif 5 contre la paroi 24'. De même l'élément 8' porte directement contre la paroi 24'.

La mise en flambage de la structure à lames afin de lui conférer un caractère bistable est effectuée, par exemple, en contraignant les côtés 26 et 28 du cadre 2 (les deux grands côtés dans l'exemple de la figure 2) vers l'extérieur, c'est-à-dire en les écartant l'un de l'autre. Cela provoque un raccourcissement entre les parois 22 et 24 (figure 2), respectivement 22 et 24' (figure 4) et, comme la distance entre les points 23 et 7 est fixe, un flambement de la structure.

On pourra prévoir d'autres solutions pour placer la structure à lames en position de flambage, par exemple, en provoquant un allongement de la structure à lames 3.

De préférence, les deux points d'appui 23 et 7 du système obtenu sont placés selon un axe sensiblement orthogonal à l'orientation Fext attendue des vibrations.

La figure 6 est une vue agrandie d'un mode de réalisation d'un dispositif 5 de conversion d'énergie adapté aux modes de réalisation de récupérateurs d'énergie décrits.

Une structure à deux lames parallèles entre elles et à masse, de préférence centrale dans la longueur de la structure, présente de nombreux avantages.

Les deux lames et le fait que leur écart soit fixe empêchent toute rotation de la structure selon un axe perpendiculaire au plan du système, notamment au niveau de la masse 4 (ou des masses pour le cas où plusieurs masses sont prévues).

De plus, cela limite tout mouvement de rotation au niveau de la liaison glissière, que celle-ci soit réalisée d'après le mode de réalisation de la figure 3 ou d'après celui de la figure 5. En effet, la position médiane de la structure, d'équilibre instable entre ses deux positions stables, est plane (dans un plan fictif parallèle aux plans dans lesquels s'inscrivent les lames), ce qui force la déformation de la liaison glissière dans l'axe (la direction médiane longitudinale) des lames.

Par conséquent, la présence de deux lames parallèles facilite la liaison avec la glissière en limitant les mouvements mécaniques sur celle-ci. Le milieu des arceaux 54 et 56 est relié, pour l'un, à l'élément 8 et, pour l'autre, au châssis 7, de préférence par l'intermédiaire d'un bras 37 rigide. Les extrémités des arceaux 54 et 56 sont fixées aux extrémités de l'élément piézoélectrique 52 (par exemple, un empilement de plaques piézoélectriques interdigitées, un barreau piézoélectrique ou toute autre structure piézoélectrique adaptée). Les liaisons 545 et 565 des milieux des arceaux 54 et 56 à l'élément 8 et au châssis 7 sont par exemple rigides (collage ou soudure), ou réalisées par l'intermédiaire de liaisons pivot. Les électrodes d'extrémité de l'élément piézoélectrique 52 sont reliées, par des fils conducteurs 58 à des circuits électriques/électroniques (non représentés) de mise en forme du signal électrique récupéré.

L'effet piézoélectrique est obtenu en déformant (écrasant, relâchant) les arceaux 54 et 56 depuis leurs parties médianes (liaisons 545 et 565), ce qui provoque une contrainte (extension, compression) de l'élément piézoélectrique 52 et génère de l'électricité. En figure 6, des flèches illustrent les contraintes lors du passage du système par la position médiane (instable). L'élément piézoélectrique 52 est contraint en extension sous l'effet d'un rapprochement des points 545 et 565 l'un vers l'autre qui provoque une élongation de l'armature.

On note que la direction active de l'élément piézoélectrique 52 est approximativement perpendiculaire à la direction de la structure à lames 3, donc approximativement parallèle à la direction des vibrations.

On aurait pu penser intercaler, dans l'alignement d'une lame ressort, un élément piézoélectrique. Toutefois cela engendrerait des contraintes trop importantes en torsion sur celui-ci. Un avantage des dispositifs de conversion décrits est que l'élément piézoélectrique 52 est protégé, les arceaux 54 et 56 conférant une forme de cadre en losange non carré dans une diagonale duquel est fixé l'élément piézoélectrique 52.

La cinématique du dispositif 1 en fonctionnement est la suivante. Partant d'une des deux positions stables, par exemple celle illustrée en trait plein en figure 2, un déplacement de l'ensemble lames 3 / masse 4 vers l'autre position stable (trait pointillé en figure 2) engendre un écrasement des arceaux 54 et 56 du dispositif 5 de conversion pour passer la position médiane, d'où un allongement de l'élément piézoélectrique 52, ce qui provoque la génération d'électricité. Le système se relâche en arrivant à l'autre position stable. Le cadre 2 et le châssis 7 sont fixés rigidement, par exemple vissés ou collés à l'équipement vibrant (6', figure 1). Les vibrations provoquent une oscillation du système entre les deux positions stables, donc la génération d'électricité.

Bien que l'on ait exposé une réalisation à un seul dispositif de conversion, on peut prévoir deux dispositifs 5 (voire plus) l'un à la suite de l'autre entre l'élément 8 et le point fixe 72.

Un avantage des modes de réalisation décrits est qu'il est désormais possible de concevoir, réaliser et assembler l'oscillateur bistable 3-4 et le convertisseur d'énergie 5 séparément, ce qui offre plus de souplesse en termes de conception et de réalisation. Le système est en outre rendu ainsi modulaire.

Un autre avantage des modes de réalisation décrits est que l'on améliore la robustesse du dispositif obtenu en réduisant les contraintes sur les connexions électriques du convertisseur 5. En effet, celui-ci n'est plus soumis à des oscillations par rapport à l'axe, liées au flambage comme ce serait le cas en la plaçant à l'intérieur du cadre 2, mais grâce à la présence d'un bilame (ou multi lames parallèles), est uniquement soumis à des déplacements axiaux. Ainsi, les raccordements (soudures) des connexions électriques sont préservés.

A titre d'exemple, la ou les lames peuvent être formées à partir d'un ruban d'acier de largeur de l'ordre de 5 à 50 mm, par exemple de l'ordre de 20 mm, et d'épaisseur de l'ordre de 100 à 500 um, par exemple de l'ordre de 200 µm. La structure à lames 3 peut avoir une longueur de 5 à 20 cm, par exemple de l'ordre de 10 cm. La masse 4 peut avoir un poids de l'ordre de 10 à 250 g, par exemple de l'ordre de 50 g. La masse 4 peut être fixée à la ou aux lames par collage, soudure, par vissage, ou tout autre moyen adapté. Bien entendu, les dimensions ci-dessus ne sont données qu'à titre d'exemple. En pratique, les dimensions du système peuvent être comprises entre quelques dixièmes de mm et quelques dizaines de cm.

Divers modes de réalisation et variantes ont été décrits. Ces divers modes de réalisation et variantes sont combinables et d'autres variantes apparaitront à l'homme de l'art. En particulier, d'autres géométries de cadre 2 pourront être prévues. Par ailleurs, bien qu'un système bilame constitue un mode de réalisation préféré par sa simplicité, on pourra prévoir plus de deux lames parallèles entre elles pour former la structure à lames 3. Enfin, la mise en oeuvre pratique des modes de réalisation décrits est à la portée de l'homme du métier à partir des indications fonctionnelles données ci-dessus, en particulier pour ce qui est de dimensions à donner aux différents éléments en fonction de l'application.

## Revendications

1. Dispositif (1) de récupération d'énergie mécanique vibratoire comportant une structure à lames (3) ressort bistable dans un cadre (2), et une liaison glissière (8, 24') au niveau d'une paroi (24, 24') du cadre entre ladite structure et au moins un dispositif de conversion mécano-électrique (5) externe au cadre,
**caractérisé en ce que** la structure à lames (3) comporte au moins deux lames (32, 34) parallèles entre elles et **en ce qu'**une masse (4) est fixée en partie centrale de la structure à lames (3), la masse (4) connectant les au moins deux lames (32, 34).

2. Dispositif selon la revendication 1, dans lequel ladite liaison glissière est obtenue par un élément (8) coulissant dans ladite paroi (24) et reliant ladite structure à lames (3) audit dispositif de conversion mécano-électrique (5).

3. Dispositif selon la revendication 1, dans lequel ladite liaison glissière est obtenue par une déformation de ladite paroi (24') entre ladite structure à lames (3) et ledit dispositif de conversion mécano-électrique (5).

4. Dispositif selon l'une quelconque des revendications 1 à 3, dans lequel le dispositif de conversion mécano-électrique (5) est relié à un point fixe (72) par rapport au cadre (2).

5. Dispositif selon l'une quelconque des revendications 1 à 4, dans lequel la structure à lames (3) est mise en flambage entre le cadre (2) et ladite liaison glissière (8, 24').

6. Dispositif selon l'une quelconque des revendications 1 à 5, dans lequel le dispositif de conversion mécano-électrique (5) comporte un élément piézoélectrique (52) dans une direction approximativement perpendiculaire à la direction de la structure à lames (3).

7. Dispositif selon la revendication 6, dans lequel le dispositif de conversion mécano-électrique (5) comporte une armature en forme de double arceau (54, 56), les milieux (545, 565) des arceaux étant reliés respectivement à la liaison glissière (8, 24') et au point fixe (72).

8. Système de production d'électricité comportant :
- un équipement (6') soumis à des vibrations mécaniques ; et
- un dispositif (1) selon l'une quelconque des revendications 1 à 7.

9. Système selon la revendication 8, dans lequel le dispositif (1) est fixé à l'équipement (6').

## Patentansprüche

1. Vorrichtung (1) zur Rückgewinnung von mechanischer Vibrationsenergie, umfassend eine bistabile Lamellenstruktur (3)-Feder in einem Rahmen (2) und eine Gleitverbindung (8, 24') an einer Wand (24, 24') des Rahmens zwischen der Struktur und mindestens einem mechanisch-elektrischen Wandler (5) außerhalb des Rahmens, **dadurch gekennzeichnet, dass** die Lamellenstruktur (3) mindestens zwei Lamellen (32, 34) aufweist , die parallel zueinander sind, und dass eine Masse (4) im mittleren Teil der Lamellenstruktur (3) befestigt ist, wobei die Masse (4) die mindestens zwei Lamellen (32, 34) verbindet.

2. Vorrichtung nach Anspruch 1, wobei die Gleitverbindung durch ein Element (8) erhalten wird, das in der Wand (24) gleitet und die Lamellenstruktur (3) mit dem mechanisch-elektrischen Wandler (5) verbindet.

3. Vorrichtung nach Anspruch 1, wobei die Gleitverbindung durch eine Verformung der Wand (24') zwischen der Lamellenstruktur (3) und dem mechanisch-elektrischen Wandler (5) erhalten wird.

4. Vorrichtung nach einem der Ansprüche 1 bis 3, wobei der mechanisch-elektrische Wandler (5) mit einem Festpunkt (72) in Bezug auf den Rahmen (2) verbunden ist.

5. Vorrichtung nach einem der Ansprüche 1 bis 4, wobei die Lamellenstruktur (3) zwischen dem Rahmen (2) und der Gleitverbindung (8, 24') geknickt wird.

6. Vorrichtung nach einem der Ansprüche 1 bis 5, wobei der mechanisch-elektrische Wandler (5) in einer Richtung etwa senkrecht zur Richtung der Lamellenstruktur (3) ein piezoelektrisches Element (52) aufweist.

7. Vorrichtung nach Anspruch 6, wobei der mechanisch-elektrische Wandler (5) eine Armatur in Form eines Doppelbügels (54, 56) aufweist, wobei die Mitten (545, 565) der Bügel jeweils mit der Gleitverbindung (8, 24') und mit dem Festpunkt (72) verbunden sind.

8. Stromerzeugungssystem, umfassend:
- eine Ausrüstung (6'), die mechanischen Vibrationen ausgesetzt ist; und
- eine Vorrichtung (1) nach einem der Ansprüche 1 bis 7.

9. System nach Anspruch 8, wobei die Vorrichtung (1) an der Ausrüstung (6') befestigt ist.

## Claims

1. A mechanical vibration energy harvesting device (1) including a bistable spring blade structure (3) in a frame (2), and a sliding joint (8, 24') at the level of a wall (24, 24') of the frame between said structure and at least one mechanical-to-electrical conversion device (5) external to the frame,
**characterised in that** the blade structure (3) comprises at least two blades (32, 34) parallel to each other and **in that** a mass (4) is attached in a central portion of the blade structure (3), the mass (4) connecting the at least deux blades (32, 34).

2. The device according to claim 1, wherein said sliding joint is obtained by an element (8) sliding in said wall (24) and coupling said blade structure (3) to said mechanical-to-electrical conversion device (5).

3. The device according to claim 1, wherein said sliding joint is obtained by a deformation of said wall (24') between said blade structure (3) and said mechanical-to-electrical conversion device (5).

4. The device according to any of claims 1 to 3, wherein the mechanical-to-electrical conversion device (5) is coupled to a fixed point (72) with respect to the frame (2).

5. The device according to any of claims 1 to 4, wherein the blade structure (3) is buckled between the frame (2) and said sliding joint (8, 24').

6. The device according to any of claims 1 to 5, wherein the mechanical-to-electrical conversion device (5) comprises a piezoelectric element (52) in a direction approximately perpendicular to the direction of the blade structure (3).

7. The device according to claim 6, wherein the mechanical-to-electrical conversion device (5) comprises a frame in the form of a double arch (54, 56), the middles (545, 565) of the arches being respectively coupled to the sliding joint (8, 24') and to the fixed point (72).

8. An electric power generation system comprising:
- an equipment (6') submitted to mechanical vibrations; and
- a device (1) according to any of claims 1 to 7.

9. The system according to claim 8, wherein the device (1) is attached to the equipment (6').
